# EUROPEAN PATENT SPECIFICATION

(11) **EP 0 975 891 B1**
(45) Date of publication and mention of the grant of the patent: **28.08.2002**
(21) Application number: 98917361.2
(22) Date of filing: 16.04.1998
(51) Int. Cl.: F16F 15/00

(54) **VIBRATION CONTROL SYSTEM, ESPECIALLY FOR CIRCUIT BOARDS**
SCHWINGUNGSDÄMPFUNGSANLAGE INSBESONDERE FÜR SCHALTPLATTEN
SYSTEME ANTI-VIBRATIONS CONNU EN PARTICULIER POUR DES CARTES DE CIRCUITS IMPRIMES

(30) Priority: 18.04.1997 GB 9707887
(43) Date of publication of application: 02.02.2000
(73) Proprietor: Marconi Optical Components Limited, London WIX 8AQ (GB)
(72) Inventor: MILLAR, Caroline, Elizabeth, Nether Hayford, Northamptonshire NN7 3NH (GB); SALLOWAY, Anthony, John, Western Favell, Northamptonshire NN3 3EP (GB); OWEN, Christopher, Edward, Barrow-in-Furness, Cumbria LA14 3RV (GB)
(74) Representative: Tolfree, Roger Keith
(86) International application number: GB9801088
(87) International publication number: WO98048197

(56) References cited:
- EP-A- 0 806 589
- GB-A- 2 259 205
- US-A- 4 367 426
- US-A- 4 565 940
- US-A- 5 473 214
- US-A- 5 485 053

## Description

The present invention relates to an active vibration control system and is particularly, but not exclusively, related to vibration control of planar structures such as printed circuit boards (PCBs).

A known method of controlling vibration uses an active system which typically comprises a sensor (which is normally piezoelectric) to detect vibration to be suppressed and control electronics to drive piezoelectric actuators. It is conventional for the sensor to be mounted on an upper surface of the actuator. The actuators are configured so as to oppose the natural bending of the structure thereby mechanically stiffening it against vibration. Active vibration control (AVC) offers the advantages of providing systems of low mass and small size which can be effective at low frequencies (several hundred hertz) through to frequencies of several kHz.

To control vibration in essentially planar structures the actuators must be optimally situated. An optimum position is the anti-node of flexure. In order to get the best performance of the AVC system the actuator should be bonded directly onto the planar structure using a thin glue layer. However, if the AVC system is to be used on a PCB then locating the actuator of the system may prove difficult since there is often little space available due to a high population of electronic tracks and components. This problem also occurs in boards which are single sided since an upper side carries components and an underside carries solder connections for the components. Locating the actuator on either side is therefore difficult.

One way of overcoming this problem is to design the PCB to have clear areas (which are not populated by tracks or components) onto which the actuator can be bonded directly. However, if it is desired to retrofit an AVC system to a PCB which has not been designed to have such clear areas, difficulties can arise in finding sites which are suitable to locate the actuator. This can result in the actuator being located at sites which are not optimal.

According to the invention there is provided an active vibration control system comprising; an actuator and at least one support element, said actuator being mountable relative to a sheet member such that the actuator is spaced apart from a surface of the sheet member and the at least one support element transmits force between the actuator and said sheet member. Such a system is known from US-A-5 485 053 (figure 25). The invention is characterised in that the at least one support element provides a clearance between said surface of the sheet member and at least a part of the actuator.

By providing a support member between the actuator and the sheet member this eliminates the need for the actuator to be in close physical proximity to the sheet member and the actuator can be located over areas which have non-planar surface topography. In this way AVC systems may be retrofitted readily to sheet members which have not had clear areas especially designed to accommodate actuators.

The term "sheet" refers to a member which is thin relative to its width and height. This means that it is prone to flexure. Although the term "sheet" primarily covers members which are planar it also covers non-planar members, for example, members which may be curved or may be undulated.

Advantageously the actuator is adapted to span areas of the sheet member occupied by features of surface topography. Conveniently this may be achieved by having a plurality of support elements each joining a relatively small area of the actuator. Advantageously the plurality of support elements are disposed around the periphery of the actuator. However the locations of the support elements may simply be dictated by being located in those areas of the sheet member which are clear of features of surface topography and available to accommodate support elements.

In a preferred embodiment having a plurality of support elements, a first pair of support elements is located at a first edge of the actuator and a second pair is located at an opposite edge of the actuator. There may be a plurality of such pairs.

The support elements may be in the form of cylinders or pieces of sheet material in the shape of circles, squares or rectangles. In an alternative preferred embodiment the plurality of support elements comprises a pair of strips which are disposed substantially parallel to each other and which are located on opposite edges of the actuator. In another preferred embodiment the support elements are cross-shaped or L-shaped. Alternatively there may be a single support element in the form of a frame which has a periphery shaped to substantially correspond to that of the actuator. The frame may be circular such as a ring, it may be rectangular or it may be some other shape.

The purpose of the support elements is to transmit force between the actuator and the sheet member and therefore their location can be determined accordingly. As a consequence whilst a regular arrangement of two support elements is preferred, it is not essential if other configurations are able to transmit sufficient force.

Preferably the or each support element comprises a metal, a glass, a ceramic or a composite material and is most preferably is alumina. However other materials may be used so long as they are sufficiently rigid to transmit force between the actuator and the sheet member.

Hitherto it has been understood that bonding between the actuator and the sheet member is necessary over the whole undersurface of the actuator in order for the actuator to transmit sufficient force to the sheet member to control vibration. Surprisingly it has been found that full contact is not required and that the actuator can perform sufficiently well if there is bonding between the actuator and the sheet member at at least two points over which the actuator forms a bridge. Contact between the "bridged" portion of the sheet member and the actuator is not required. Although it is preferred that the distance between these two points be substantially the same distance as the length of the actuator, it may be less. A lesser distance may simply compromise performance.

According to a further aspect of the invention is provided a sheet member incorporating an active vibration control system as described above. Most preferably the sheet member is a printed circuit board and the features of the surface topography are electronic tracks and/or electronic components. A particular advantage of the present invention is that the clearance formed between the actuator and the sheet member forms an air gap allowing uninhibited heat dissipation from such components.

An embodiment of the invention will now be described by way of example only with reference to the accompanying drawings in which:
Figure 1 shows an arrangement of an actuator and a support element;
Figure 2 shows an alternative arrangement of an actuator and support elements;
Figures 3a and 3b show further arrangements of an actuator and support elements;
Figures 4a and 4b show the arrangement of Figure 3a mounted on a printed circuit board; and
Figures 5a and 5b show yet further arrangements of an actuator and support elements mounted on a printed circuit board.

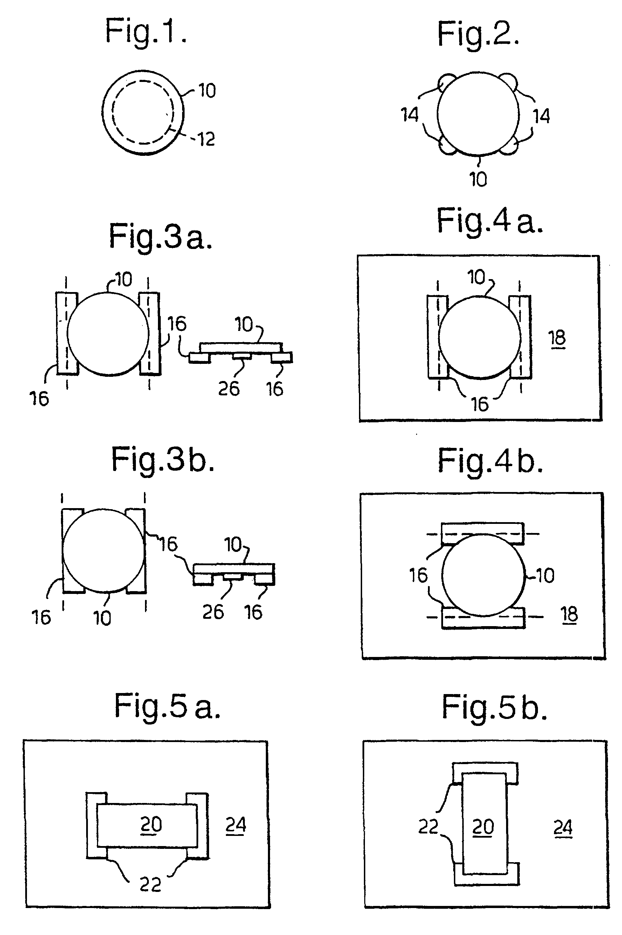

Figure 1 shows an actuator 10 bonded to a support element 12 which comprises a ring frame. The support element 12 is made of alumina which is a rigid material thus providing a good medium for transmitting force exerted by the actuator to a PCB to which the support element is bonded. Other rigid materials such as other ceramics or metals could serve equally well.

Figure 2 shows an alternative arrangement in which the actuator 10 is bonded to support elements comprising four pads, or feet, 14 which are made of alumina.

Figure 3a shows the actuator 10 bonded to support elements comprising alumina strips 16 such that a side part of each strip extends beyond the actuator 10. Figure 3b shows the actuator 10 bonded to two alumina strips 16 such that the edges of the actuator extend as far as the edges of the sides of the strips 16. This provides a more compact arrangement.

Figure 4a shows the arrangement of Figure 3a in which the actuator 10 is bonded to the alumina strips 16 which are in turn bonded longitudinally to a PCB 18. The actuator 10 straddles the strips 16 in such a way as to form a bridge arrangement in which components on the PCB 18 can be accommodated between the strips 16 and beneath the actuator 10.
Figure 4b shows a similar arrangement to Figure 4a in which the strips are bonded transversely to the PCB 18.

Figure 5a shows an arrangement using an elongate actuator 20 which is supported by support elements comprising alumina strips 22 which are similar to the strips 1G. The actuator 20 is bonded longitudinally to a PCB 24. Figure 5b shows an arrangement in which an elongate actuator 20 is bonded transversely to a PCB 24. In the embodiments of Figures 5a and 5b the actuator 20 has dimensions of 30 x 15 x 1mm.

In the foregoing embodiments the support elements generally have a thickness of about 1mm. In one preferred embodiment the thickness is about 3mm.

Longitudinal or transverse orientation of the actuator on the PCB depends on the vibration mode or modes present in the PCB and will be chosen to optimise vibration control.

In an alternative embodiment alumina supports are not used. Instead the actuator is mounted on a glue layer which is thick enough for the actuator to be supported above the tracks, components or both on the PCB. In such an embodiment the glue material must be sufficiently rigid in order to transmit enough force from the actuator to control vibration. Suitable glues are cyanoacrylate or epoxy resin. Reinforced epoxy resin, such as that reinforced with glass or carbon fibre, is preferred.

The actuators described in the foregoing description may be piezoelectric, such as PZT (lead zirconium tantalate) or electrostrictive, such as PMN (lead manganese niobate).

In a preferred embodiment the actuator, sensor, electronics and support element or members are packaged as an assembly in an enclosure. The enclosure comprises a carbon fibre or glass fibre composite material. In a variant of this embodiment the actuator and sensor are packaged in a first enclosure and the electronics are packaged in a second enclosure. A two enclosure arrangement can be more squat occupying a relatively greater plan area of a PCB but a relatively lesser height. This is important because PCBs are usually stacked one above another and minimising the height of AVC systems can be useful.

The system operates over a frequency range from several hertz (for example I to 10 Hz) to several kHz (for example 1, 2, 3, 4 or 5 kHz). The lower end of the range extends as far down as DC (that is 0Hz)

In the embodiments according to the invention described above one or more support elements are provided between the actuator and the PCB. The presence of one or more support elements can provide a convenient location to locate the sensor since it may be located between the actuator and the PCB or on a support element. A sensor is shown in Figures 3a and 3b and designated by numeral 26. If the sensor is of the accelerometer type it may be mounted beneath the actuator, perhaps bonded to its underside, on the PCB or on (or even in) a support element. If the sensor is a strain sensor it may be mounted on the PCB to detect strain in the PCB. An advantage of locating the sensor in a location other than on top of the actuator is that a more squat arrangement may be obtained.

## Claims

1. An active vibration control system comprising; an actuator (10, 20) and at least one support element (12, 14,16, 22), said actuator (10, 20) being mountable relative to a sheet member (18, 24) such that the actuator (10, 20) is spaced apart from a surface of the sheet member (18, 24) and the at least one support element (12, 14, 16, 22) transmits force between the actuator (10, 20) and said sheet member (18, 24) **characterised in that** the at least one support element provides a clearance between said surface of the sheet member (18, 24) and at least a part of the actuator (10, 20).

2. A system according to Claim 1 and further **characterised in that** the actuator (10, 20) is adapted to span areas of the sheet member (18, 24) occupied by features of surface topography.

3. A system according to Claim 1 or Claim 2 and further **characterised in that** there are a plurality of support elements (14, 16, 22) each joining a relatively small area of the actuator (10, 20).

4. A system according to Claim 3 and further **characterised in that** the plurality of support elements are disposed around the periphery of the actuator (10, 20)

5. A system according to Claim 3 or Claim 4 and further **characterised in that** a first pair of support elements (14) is located at a first edge of the actuator (10) and a second pair (14) is located at an opposite edge of the actuator (10).

6. A system according to Claim 3 or Claim 4 and further **characterised in that** the support elements (16, 22) comprise a pair of strips (16, 22) which are disposed substantially parallel to each other and located on opposite edges of the actuator (20).

7. A system according to Claim 5 or Claim 6 in which there is a plurality of such pairs.

8. A system according to Claim 1 or Claim 2 **characterised in that** there is a single support element (12) in the form of a frame which has a periphery shaped to substantially correspond to that of the actuator (10).

9. A system according to any preceding claim and further **characterised in that** the or each support element (12, 14, 16, 22) comprises a material selected from a metal, a glass, a ceramic or a composite material.

10. A system according to Claim 9 and **characterised in that** the material is alumina.

11. A system according to any one of Claims 1 to 8 and **characterised in that** the or each support element comprises a glue layer.

12. A system according to any preceding claim and further **characterised by** a sensor (26) provided between the actuator (10, 20) and said surface of the sheet member (18, 24).

13. A sheet member (18, 24) incorporating an active vibration control system according to any preceding claim.

14. A sheet member (18, 24) according to Claim 13 when dependent on Claim 2 and further **characterised in that** the sheet member is a printed circuit board and said features of surface topography are electronic tracks and/or electronic components.

## Patentansprüche

1. Aktives Schwingungsregelungssystem, umfassend: ein Stellglied (10, 20) und mindestens ein Stützelement (12, 14, 16, 22), wobei das Stellglied (10, 20) in Bezug auf ein schichtartiges Element (18, 24) in solcher Weise montierbar ist, dass das Stellglied (10, 20) im Abstand von einer Oberfläche des schichtartigen Elements (18, 24) angeordnet ist und dass das wenigstens eine Stützelement (12, 14, 16, 22) eine Kraft zwischen dem Stellglied (10, 20) und dem schichtartigen Element (18, 24) überträgt,
**dadurch gekennzeichnet,**
**dass** das wenigstens eine Stützelement einen Zwischenraum zwischen der Oberfläche des schichtartigen Elements (18, 24) und zumindest einem Teil des Stellglieds (10, 20) bereitstellt.

2. System nach Anspruch 1 und ferner **dadurch gekennzeichnet,**
**dass** das Stellglied (10, 20) dazu angepasst ist, Bereiche des schichtartigen Elements (18, 24) zu überspannen, die von Merkmalen der Oberflächentopographie eingenommen sind.

3. System nach Anspruch 1 oder Anspruch 2 und ferner
**dadurch gekennzeichnet,**
**dass** mehrere Stützelemente (14, 16, 22) vorhanden sind, die jeweils mit einer relativ kleinen Fläche des Stellglieds verbunden sind.

4. System nach Anspruch 3 und ferner **dadurch gekennzeichnet,**
**dass** die mehreren Stützelemente um den Umfang des Stellglieds (10, 20) herum angeordnet sind.

5. System nach Anspruch 3 oder Anspruch 4 und ferner
**dadurch gekennzeichnet,**
**dass** ein erstes Paar von Stützelementen (14) an einem ersten Rand des Stellglieds (10) angeordnet ist und ein zweites Paar (14) an dem gegenüberliegenden Rand des Stellglieds (10) angeordnet ist.

6. System nach Anspruch 3 oder Anspruch 4 und ferner
**dadurch gekennzeichnet,**
**dass** die Stützelemente (16, 22) ein Paar von Streifen (16, 22) umfassen, die im Wesentlichen parallel zueinander ausgerichtet sind und an gegenüberliegenden Rändern des Stellglieds (20) angeordnet sind.

7. System nach Anspruch 5 oder Anspruch 6, bei welchem mehrere solcher Paare vorhanden sind.

8. System nach Anspruch 1 oder Anspruch 2, **dadurch gekennzeichnet,**
**dass** ein einziges Stützelement (12) in Form eines Rahmens vorhanden ist, dessen Umfang derartig geformt ist, dass er im Wesentlichen dem des Stellglieds (10) entspricht.

9. System nach einem der vorhergehenden Ansprüche und ferner **dadurch gekennzeichnet,**
**dass** das oder jedes Stützelement (12, 14, 16, 22) ein Material umfasst, das aus folgenden ausgewählt ist: ein Metall, ein Glas, eine Keramik oder ein Kompositmaterial.

10. System nach Anspruch 9 und **dadurch gekennzeichnet,**
**dass** das Material Aluminiumoxid ist.

11. System nach einem der Ansprüche 1 bis 8 und **dadurch gekennzeichnet,**
**dass** das oder jedes Stützelement eine Klebstoffschicht umfasst.

12. System nach einem der vorhergehenden Ansprüche und ferner **gekennzeichnet**
**durch** einen Sensor (26), der zwischen dem Stellglied (10, 20) und der Oberfläche des schichtartigen Elements (18, 24) vorgesehen ist.

13. Schichtartiges Element (18, 24), das ein aktives Schwingungsregelungssystem gemäß einem der vorhergehenden Ansprüche umfasst.

14. Schichtartiges Element (18, 24) nach Anspruch 13, wenn von Anspruch 2 abhängig, und ferner **dadurch gekennzeichnet,**
**dass** das schichtartige Element eine gedruckte Schaltungsplatine ist und dass die Merkmale der Oberflächentopographie elektronische Bahnen und/oder elektronische Komponenten sind.

## Revendications

1. Système de commande active de vibrations comportant : un actionneur (10, 20) et au moins un élément de support (12, 14, 16, 22), ledit actionneur (10, 20) pouvant être monté par rapport à un élément formant plaque (18, 24) de telle sorte que l'actionneur (10, 20) soit espacé à partir d'une surface d'élément formant plaque (18, 24) et le au moins un élément de support (12, 14, 16, 22) transmet une force entre l'actionneur (10, 20) et ledit élément formant plaque (18, 24), **caractérisé en ce que** le au moins un élément de support fournit un jeu entre ladite surface de l'élément formant plaque (18, 24) et au moins une partie de l' actionneur (10, 20).

2. Système selon la revendication 1, et en outre **caractérisé en ce que** l'actionneur (10, 20) est adapté pour s'étendre sur des surfaces de l'élément formant plaque (18, 24) occupées par des caractéristiques d'une topographie de surface.

3. Système selon la revendication 1 ou 2, et en outre **caractérise en ce qu'**il y a une pluralité d'éléments de support (14, 16, 22) reliant chacun une surface relativement petite de l'actionneur (10, 20).

4. Système selon la revendication 3, et en outre **caractérisé en ce que** la pluralité d'éléments de support est disposée à la périphérie de l'actionneur (10, 20).

5. Système selon la revendication 3 ou 4, et en outre **caractérisé en ce qu'**une première paire d'éléments de support (14) est positionnée à un premier bord de l'actionneur (10) et une seconde paire (14) est positionnée sur un bord opposé de l'actionneur (10).

6. Système selon la revendication 3 ou 4, et en outre **caractérisé en ce que** les éléments de support (16, 22) sont constitués d'une paire de bandes (16, 22) qui sont disposées sensiblement parallèlement l'une à l'autre et positionnées sur des bords opposés de l'actionneur (20).

7. Système selon la revendication 5 ou 6, dans lequel il existe une pluralité de telles paires.

8. Système selon la revendication 1 ou 2, **caractérisé en ce qu'**il existe un seul élément de support (12) ayant la forme d'un châssis qui a une périphérie formée pour correspondre sensiblement à celle de l'actionneur (10).

9. Système selon l'une quelconque des revendications précédentes, et en outre **caractérisé en ce que** l'élément de support ou chaque élément de support (12, 14, 16, 22) est constitué d'un matériau sélectionné parmi un métal, du verre, une céramique ou un matériau composite.

10. Système selon la revendication 9, et **caractérisé en ce que** le matériau est de l'alumine.

11. Système selon l'une quelconque des revendications 1 à 8, et **caractérisé en ce que** l'élément de support ou chaque élément de support comporte une couche de colle.

12. Système selon l'une quelconque des revendications précédentes, et en outre **caractérisé par** un capteur (26) agencé entre l'actionneur (10, 20) et ladite surface de l'élément formant plaque (18, 24).

13. Elément formant plaque (18, 24) incorporant un système de commande actif de vibrations selon l'une quelconque des revendications précédentes.

14. Elément formant plaque (18, 24) selon la revendication 13 lorsqu'elle dépend de la revendication 2, et en outre **caractérisé en ce que** l'élément formant plaque est une carte à circuit imprimé et lesdites caractéristiques de topographie de surface sont des pistes électroniques et/ou des composants électroniques.
